# EUROPEAN PATENT SPECIFICATION

(11) **EP 2 094 972 B1**
(45) Date of publication and mention of the grant of the patent: **21.10.2015**
(21) Application number: 07849387.1
(22) Date of filing: 10.12.2007
(51) Int. Cl.: F04F 7/00, H01L 23/467

(54) **PULSATING FLUID COOLING WITH FREQUENCY CONTROL**
PULSIERENDE FLÜSSIGKEITSKÜHLUNG MIT FREQUENZSTEUERUNG
REFROIDISSEMENT PAR FLUIDE PULSÉ À COMMANDE DE FRÉQUENCE

(30) Priority: 15.12.2006 EP 06126250
(43) Date of publication of application: 02.09.2009
(73) Proprietor: Koninklijke Philips N.V., 5656 AE Eindhoven (NL)
(72) Inventor: AARTS, Ronaldus M., 5656 AE Eindhoven (NL)
(74) Representative: Bekkers, Joost J.J.
(86) International application number: PCT/IB2007/054981
(87) International publication number: WO 2008/075245

(56) References cited:
- EP-A- 1 529 963
- WO-A-2005/008348
- WO-A-2005/027569
- WO-A-2005/080793
- WO-A-2005/091362
- US-B1- 6 625 285

## Description

### FIELD OF THE INVENTION

The present invention relates to pulsating fluid cooling, i.e. cooling where a transducer induces an oscillation creating a pulsating fluid stream that can be directed towards an object that is to be cooled. It may be advantageous to drive the system at, or at least close to, its resonance frequency, in order to obtain a high fluid velocity.

### BACKGROUND OF THE INVENTION

The need for cooling has increased in various applications due to higher heat flux densities resulting from newly developed electronic devices, being, for example, more compact and/or higher power than traditional devices. Examples of such improved devices include, for example, higher power semiconductor light-sources, such as lasers or light-emitting diodes, RF power devices and higher performance micro-processors, hard disk drives, optical drives like CDR, DVD and Blue ray drives, and large-area devices such as flat TVs and luminaires.

As an alternative to cooling by fans, document WO 2005/008348 discloses a synthetic jet actuator and a tube for cooling purposes. The tube is connected to a resonating cavity, and a pulsating jet stream is created at the distal end of the tube, and can be used to cool an object. The cavity and the tube form a Helmholtz resonator, i.e. a second order system where the air in the cavity acts as a spring, while the air in the tube acts as the mass.

Another example is given by N. Beratlis et al, Optimization of synthetic jet cooling for microelectronics applications, 19^{th} SEMITHERM San Jose, 2003. Here a synthetic jet is disclosed having two diaphragms each communicating with the same orifice.

A pulsating fluid stream (typically air stream) of this kind has been found to be more efficient for cooling than laminar flow, as typically used in conventional cooling systems (e.g. cooling fans). The resonance cooling systems further require less space, and generates less noise.

In order to obtain maximum efficiency, such pulsating cooling systems are preferably driven at a specific working frequency, e.g. the resonance frequency or anti-resonance frequency of the system. Prior art cooling devices lack satisfactory means to ensure such efficient driving.

More generally stated, conventional pulsating cooling devices lack the ability to adapt and control the working frequency of the transducer based on the conditions and performance of the cooling device.

### SUMMARY OF THE INVENTION

It is therefore an object of the present invention to enable adaptation of the working frequency of a pulsating cooling device to the conditions and performance of the cooling system.

According to a first inventive concept, this and other objects are achieved by a pulsating fluid cooling device comprising a transducer for generating a pulsating fluid flow, a fluid guiding structure for directing the pulsating flow towards an object to be cooled, a sensor for detecting at least one variable representing a condition of the object, a feedback path for providing a feedback signal indicative of this variable, and control circuitry arranged to receive the feedback signal and to generate a frequency control signal based on said feedback, for controlling a working frequency of the transducer. Control of the working frequency is thus performed based on an external feedback path, which may provide information from the object to be cooled. Such information may include, but is not limited to: a temperature change of the object, a fluid flux in a vicinity of the object, a fluid velocity in a vicinity of the object, etc.

The frequency control will thus enable adaptation of the working frequency to the performance of the cooling device. For example, such frequency control can be utilized to ensure satisfactory cooling efficiency.

By providing the control circuitry with information about the conditions at the object, the frequency can be controlled based on actual performance. The performance can be optimized in terms of the measured variable. For example, if the feedback signal includes information about the temperature change of the object, the control circuitry can be arranged to select a working frequency that results in optimal cooling.

According to a second inventive concept, a pulsating fluid cooling device comprises a transducer for generating a pulsating fluid flow, a fluid guiding structure for directing the pulsating flow towards an object to be cooled, a combination unit for combining a first signal indicative of the phase of the voltage across the transducer and a second signal indicative of the phase of the current through the transducer, so as to generate a phase difference signal, and control circuitry for controlling the frequency of the transducer in accordance with this phase difference signal.

In this case, the working frequency is the resonance frequency or the anti-resonance frequency of the device (i.e. transducer and guiding structure), and the control unit is arranged to ensure this working frequency.

Such circuitry, for ensuring resonance frequency driving, is disclosed in the document WO 2005/027569, but has not been suggested for use in a pulsating fluid cooling device. This combination is therefore novel per se.

In the context of the first inventive concept, a control system according to WO 2005/027569 is complemented by the external feedback from the sensor, thereby enabling adjustments of the control strategy based on resonance frequency control in combination with external feedback (such as temperature).

### BRIEF DESCRIPTION OF THE DRAWINGS

This and other aspects of the present invention will now be described in more detail, with reference to the appended drawings showing a currently preferred embodiment of the invention.
Figure 1 is a schematic view of a pulsating fluid cooling device according to an embodiment of the invention.
Figure 2 is a block diagram of a first alternative of the controller in figure 1.
Figure 3 is a schematic view of a pulsating fluid cooling device according to the invention.
Figure 4 is a block diagram of a second alternative of the controller in figure 1.

### DETAILED DESCRIPTION OF PREFERRED EMBODIMENTS

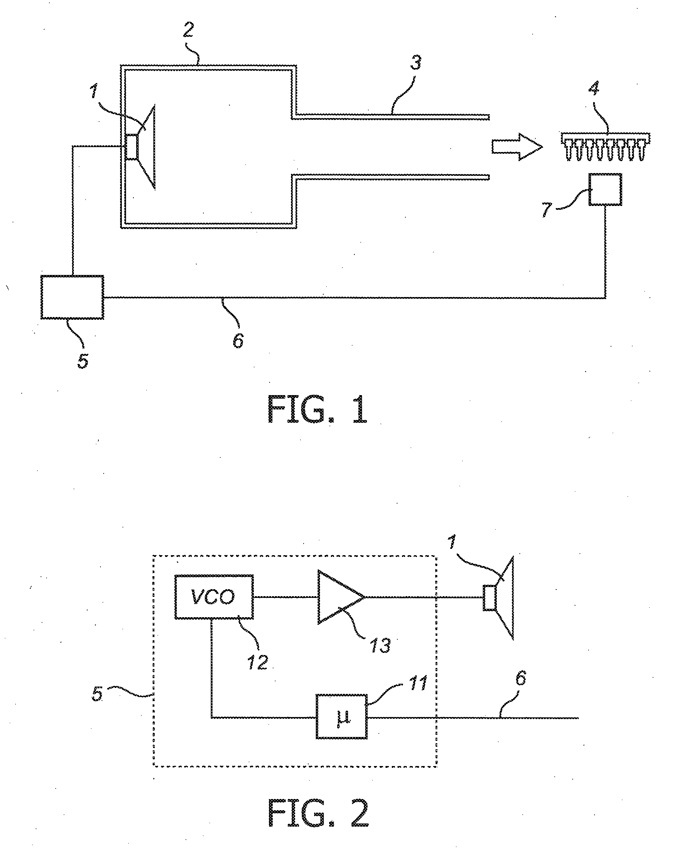

Figure 1 shows an embodiment of a pulsating fluid cooling system according to an embodiment of the present invention. The system comprises a transducer 1, arranged in an enclosure 2, and a fluid directing structure 3, here in the form of a tube extending from the cavity. In operation, the transducer creates a pulsating fluid flow, that is directed by the fluid directing structure towards an object 4 to be cooled, such as an integrated circuit.

The system further comprises a control unit 5, adapted to control the frequency of the transducer, in order to optimize the cooling process. A feedback path 6 is adapted to provide a feedback signal to the control unit. The feedback signal represents a variable external to the cooling device, and may advantageously be related to a physical quantity the object 4. The feedback signal can be generated by a sensor 7.

In the illustrated example, the feedback signal relates to the temperature of the object, and the sensor 7 is designed to generate a signal indicative of the temperature.

According to one embodiment, the sensor is arranged to detect a current flowing through an object 4 in the form of an IC. By performing the measurement at a position exposed to a constant voltage difference, the detected current will be indicative of the temperature of the IC.

According to another embodiment, the sensor is a more conventional temperature transmitter, providing a voltage proportional to the temperature that the sensor is subjected to.

An example of a control unit 5 is illustrated in figure 2. The unit 5 comprises a processing unit 11, a voltage controlled oscillator (VCO) 12, and an operational amplifier 13. The processing unit 11 is connected to the feedback path 6, and receives the feedback signal, e.g. a temperature indication from a sensor 7. Based on this feedback, the processing unit 11 determines a frequency suitable for achieving a desired cooling performance, and provides a voltage corresponding to this frequency to the VCO 12. The VCO 12 oscillates at the requested frequency, and its output is supplied to the operational amplifier 13, which in turn is connected to the transducer 1.

The processing in the processing unit 11 depends on the feedback provided, and also of the desired performance. According to one example, the processing unit 11 is adapted to monitor a temperature change of the object 4 in relation to the applied frequency. Form this relationship, an absolute or local minimum can be selected, i.e. a frequency for which the temperature of the object 4 is minimal. This corresponds to the currently most efficient cooling frequency. Note that such feedback ensures that an optimal frequency is maintained also in a dynamic process, i.e. in case the optimal cooling frequency should vary over time. Another to another example, the feedback signal relates to a net fluid flux in close vicinity of the object 4. The processing unit can then adjust the frequency so as to ensure a maximum net flux, which typically will ensure satisfactory cooling.

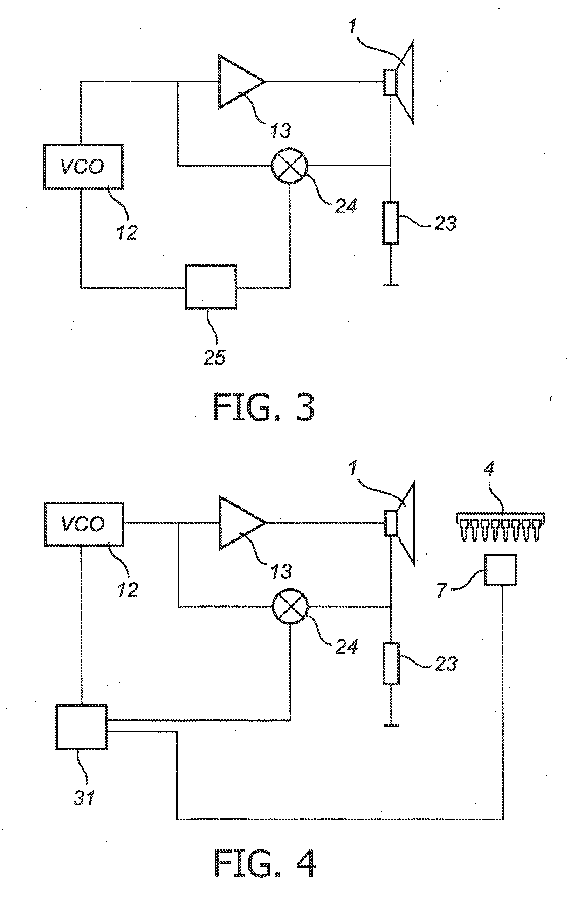

A different embodiment of the invention is illustrated in figure 3. Here, the transducer 1 is arranged to be controlled at a working frequency equal to the resonance frequency or anti-resonance frequency of the device. Characteristic for these working frequencies is that they will result in a voltage across the transducer in phase with the current flowing through the transducer. The frequency control can therefore be based on this relationship.

The control circuitry in figure 3 comprises a voltage controlled oscillator (VCO) 12, connected to the transducer via an operational amplifier 13. It further comprises a resistor 23 connected between the transducer coil and ground. The voltage across the resistor V_{R} will thus be in phase with the current through the coil. This voltage V_{R} is connected to a combination unit 24, e.g. a multiplier, also provided with the drive voltage from the VCO 12, V_{VCO}. The output of the combination unit 24 is connected to a control unit 25, which in turn controls the VCO 12.

The output from the combination unit 24 is representative of a phase difference between the voltages V_{R} and V_{VCO}. The control unit 25 provides a control signal to the VCO 12 based on the phase difference, so as to control the VCO 12 to generate a resonance (or anti-resonance) frequency. The details of such control are described in WO 2005/027569, herewith incorporated by reference.

As illustrated in figure 4, the control schemes of figures 2 and 3 may be combined. The resulting control will thus combine external feedback control, as shown in figure 2, with a phase difference control, as described in figure 4. Most elements in figure 4 correspond to the elements in figure 2 and 3, and have therefore been given identical reference numerals and will only be described in terms of their function.

The control unit 31 is here adapted to receive two feedback signals; one external, from the sensor 7, and one internal, from the combination unit 24. Just as in figure 3, the control unit 31 is adapted to perform frequency control based on the phase difference signal from the combination unit 24. However, the target phase difference does not need to be zero, as in figure 3. Instead, a target phase difference is determined by the control unit based on the external feedback, thus allowing an optimization of the cooling process, as outlined above with reference to figure 2.

The person skilled in the art realizes that the present invention by no means is limited to the preferred embodiments described above. On the contrary, many modifications and variations are possible within the scope of the appended claims. For example, various other types of sensors may be employed to provide suitable feedback. Further, a variety of control schemes may be developed in order to optimize and improve the cooling performance based on available feedback.

## Claims

1. A pulsating fluid cooling device comprising a transducer (1) for generating a pulsating fluid flow and a fluid guiding structure (3) for directing the pulsating flow towards an object (4) to be cooled, **characterized by**:
a sensor (7) for detecting at least one variable external to the transducer,
a feedback path (6) for providing a feedback signal indicative of this variable, and
control circuitry (5) arranged to receive the feedback signal and generate a frequency control signal based on said feedback, for controlling a working frequency of the transducer,
wherein the working frequency is the resonance frequency or the anti-resonance frequency of the device.

2. The cooling device according to claim 1, wherein said variable relates to conditions at the object (4) to be cooled.

3. The cooling device according to claim 2, wherein said variable relates to one of a temperature change of the object, a fluid flux in a vicinity of the object and a fluid velocity in a vicinity of the object.

4. The cooling device according to any one of the preceding claims, wherein the control circuitry (5) includes a voltage controlled oscillator (12).

5. The cooling device according to any one of the preceding claims, wherein the control circuitry (5) includes:
a combination unit (24) for combining a first signal indicative of the phase of the voltage across the transducer (1) and a second signal indicative of the phase of the current through the transducer, so as to generate a phase difference signal, and
a control unit (31) for generating said frequency control signal based on this phase difference signal.

6. A method for cooling an object (4) by generating said pulsating fluid flow and directing said fluid flow towards said object (4), said method **characterized by**:
detecting at least one variable external to the transducer,
providing a feedback signal indicative of this variable, and
generating a frequency control signal based on said feedback, and
using said control signal to control a working frequency of the transducer,
wherein the working frequency is the resonance frequency or the anti-resonance frequency of the device.

7. The method according to claim 6, wherein said variable relates to conditions at the object (4) to be cooled.

8. The method according to claim 7, wherein said variable relates to one of a temperature change of the object, a fluid flux in a vicinity of the object and a fluid velocity in a vicinity of the object.

## Patentansprüche

1. Einrichtung zur pulsierenden Flüssigkeitskühlung, umfassend einen Messwandler (1) zur Erzeugung eines pulsierenden Flüssigkeitsstroms sowie eine Flüssigkeitsführungsstruktur (3), um den pulsierenden Strom zu einem zu kühlenden Objekt (4) hin zu leiten, **gekennzeichnet durch**:
einen Sensor (7), um mindestens eine Variable außerhalb des Messwandlers zu detektieren;
einen Rückführpfad (6), um ein für diese Variable indikatives Rückführsignal vorzusehen; sowie
eine Steuerschaltung (5), die so eingerichtet ist, dass sie das Rückführsignal empfängt und aufgrund des Rückführsignals ein Frequenzsteuersignal zur Steuerung einer Arbeitsfrequenz des Messwandlers erzeugt,
wobei die Arbeitsfrequenz die Resonanzfrequenz oder die Anti-Resonanzfrequenz der Einrichtung ist.

2. Kühleinrichtung nach Anspruch 1, wobei die Variable auf Zustände an dem zu kühlenden Objekt (4) bezogen ist.

3. Kühleinrichtung nach Anspruch 2, wobei die Variable auf eine Temperaturänderung des Objekts, einen Flüssigkeitsfluss in der nahen Umgebung des Objekts oder eine Flüssigkeitsgeschwindigkeit in der nahen Umgebung des Objekts bezogen ist.

4. Kühleinrichtung nach einem der vorangegangenen Ansprüche, wobei die Steuerschaltung (5) einen spannungsgesteuerten Oszillator (12) umfasst.

5. Kühleinrichtung nach einem der vorangegangenen Ansprüche, wobei die Steuerschaltung (5) umfasst:
eine Kombinationseinheit (24) zum Kombinieren eines für die Phase der Spannung an dem Messwandler (1) indikativen ersten Signals und eines für die Phase des Stroms durch den Messwandler indikativen zweiten Signals, um ein Phasendifferenzsignal zu erzeugen, sowie
eine Steuereinheit (31) zur Erzeugung des Frequenzsteuersignals auf der Basis dieses Phasendifferenzsignals.

6. Verfahren zum Kühlen eines Objekts (4), indem der pulsierende Flüssigkeitsstrom erzeugt und der Flüssigkeitsstrom zu dem Objekt (4) hin gerichtet wird, wobei das Verfahren **dadurch gekennzeichnet ist, dass**
mindestens eine Variable außerhalb des Messwandlers detektiert wird,
ein für diese Variable indikatives Rückführsignal vorgesehen wird, und
aufgrund des Rückführsignals ein Frequenzsteuersignal erzeugt wird, und
das Steuersignal zur Steuerung einer Arbeitsfrequenz des Messwandlers verwendet wird, wobei die Arbeitsfrequenz die Resonanzfrequenz oder die Anti-Resonanzfrequenz der Einrichtung ist.

7. Verfahren nach Anspruch 6, wobei die Variable auf Zustände an dem zu kühlenden Objekt (4) bezogen ist.

8. Verfahren nach Anspruch 7, wobei die Variable auf eine Temperaturänderung des Objekts, einen Flüssigkeitsfluss in der nahen Umgebung des Objekts oder eine Flüssigkeitsgeschwindigkeit in der nahen Umgebung des Objekts bezogen ist.

## Revendications

1. Dispositif de refroidissement à fluide à impulsions, comprenant un transducteur (1) pour produire un écoulement de fluide à impulsions et une structure de guidage de fluide (3) pour diriger l'écoulement à impulsions vers un objet (4) destiné à être refroidi, **caractérisé par** :
un capteur (7) pour détecter au moins une variable externe au transducteur,
un chemin de rétroaction (6) pour fournir un signal de rétroaction indicatif de cette variable, et
une circuiterie de commande (5) agencée pour recevoir le signal de rétroaction et générer un signal de commande de fréquence en fonction de ladite rétroaction, pour commander une fréquence de fonctionnement du transducteur,
dans lequel la fréquence de fonctionnement est la fréquence de résonance ou la fréquence d'antirésonance du dispositif

2. Dispositif de refroidissement selon la revendication 1, dans lequel ladite variable concerne des conditions au niveau de l'objet (4) destiné à être refroidi.

3. Dispositif de refroidissement selon la revendication 2, dans lequel ladite variable concerne un parmi un changement de température de l'objet, un flux de fluide dans un voisinage de l'objet et une vitesse de fluide dans un voisinage de l'objet.

4. Dispositif de refroidissement selon l'une quelconque des revendications précédentes, dans lequel la circuiterie de commande (5) comprend un oscillateur commandé en tension (12).

5. Dispositif de refroidissement selon l'une quelconque des revendications précédentes, dans lequel la circuiterie de commande (5) comprend :
une unité de combinaison (24) pour combiner un premier signal indicatif de la phase de la tension sur le transducteur (1) et un second signal indicatif de la phase du courant à travers le transducteur, afin de générer un signal de différence de phase, et
une unité de commande (31) pour générer ledit signal de commande de fréquence en fonction de ce signal de différence de phase.

6. Procédé pour refroidir un objet (4) en produisant ledit écoulement de fluide à impulsions et en dirigeant ledit écoulement de fluide vers ledit objet (4), ledit procédé état **caractérisé par** :
la détection d'au moins une variable externe au transducteur,
la fourniture d'un signal de rétroaction indicatif de cette variable, et
la génération d'un signal de commande de fréquence en fonction de ladite rétroaction, et
l'utilisation dudit signal de commande pour commander une fréquence de fonctionnement du transducteur, dans lequel la fréquence de fonctionnement est la fréquence de résonance ou la fréquence d'antirésonance du dispositif

7. Procédé selon la revendication 6, dans lequel ladite variable concerne des conditions au niveau de l'objet (4) destiné à être refroidi.

8. Procédé selon la revendication 7, dans lequel ladite variable concerne un parmi un changement de température de l'objet, un flux de fluide dans un voisinage de l'objet et une vitesse de fluide dans un voisinage de l'objet.
